Europäisches Patentamt

European Patent Office

Office européen des brevets

(19)

(11) Veröffentlichungsnummer : **0 209 776**
**B1**

(12) **EUROPÄISCHE PATENTSCHRIFT**

(45) Veröffentlichungstag der Patentschrift :
24.01.90

(21) Anmeldenummer : 86109210.4

(22) Anmeldetag : 05.07.86

(51) Int. Cl.$^5$ : **C 03 C   8/02**

(54) **Emaillierungen mit heterogenem Gefüge.**

(30) Priorität : 20.07.85 DE 3525972

(43) Veröffentlichungstag der Anmeldung :
28.01.87 Patentblatt 87/05

(45) Bekanntmachung des Hinweises auf die Patenterteilung : 24.01.90 Patentblatt 90/04

(84) Benannte Vertragsstaaten :
BE FR GB IT NL

(56) Entgegenhaltungen :
FR--A-- 2 531 700
GB--A-- 1 459 178
GB--A--˙2 080 281
US--A-- 4 358 541

(73) Patentinhaber : BAYER AG

D-5090 Leverkusen 1 Bayerwerk (DE)

(72) Erfinder : Hees, Bruno, Dipl.-Ing.
Zum Stadion 55
D-4018 Langenfeld (DE)
Erfinder : Hoffmann, Hans, Dr.
Landrat-Trimbornstrasse 60
D-5653 Leichlingen (DE)
Erfinder : Florjancic, Matjaz, Dr.
Staffelseeweg 9
D-7000 Stuttgart (DE)
Erfinder : Richter, Horst, Dr.
Tiergartenstrasse 29
D-7030 Böblingen (DE)
Erfinder : Ruess, Karin, Dipl.-Chem.
Bussenstrasse 27
D-7000 Stuttgart (DE)
Erfinder : Smernos, Stauros, Dr.
Birkenwaldstrasse 127
D-7000 Stuttgart (DE)
Erfinder : Thaidigsmann, Otto
Rotenbergerstrasse 112
D-7000 Stuttgart (DE)

EP 0 209 776 B1

## Beschreibung

Die vorliegende Erfindung betrifft Emaillierungen mit heterogenem Gefüge, die aus mindestens zwei unterschiedlichen Phasen bestehen. Diese Emaillierungen zeichnen sich durch hohe mechanische und thermische Stabilität, durch niedrige thermische Ausdehnungskoeffizienten, hohen Isolationswiderstand und hervorragende elektrische Eigenschaften aus.

Derartig emaillierte Metallkerne eignen sich in besonderer Weise als Substrate für den Aufbau von Leiterplatten und elektronischen Schaltungen. Die Emailschicht wirkt als Isolator, auf dem metallische Schaltungsstrukturen aufgebracht werden können. Mit zugefügten aktiven (IC) und passiven Bauelementen lassen sich mit derartigen Leiterplatten elektronische Baugruppen realisieren.

Seit vielen Jahren Stand der Technik ist der Aufbau elektronischer Schaltungen auf Phenolharzpapier- und Epoxy-Glas Leiterplatten, sowie auf $Al_2O_3$ Substraten.

Die konventionellen Kunststoffleiterplatten genügen jedoch in vielen Fällen nicht mehr den physikalischen und elektrischen Anforderungen, die durch neue Halbleiterbauelemente gestellt werden. Vor allem in Hinblick auf hohe Verlustleistungen der Bauelemente werden Hilfskonstruktionen für die Entwärmung gesucht.

$Al_2O_3$ Substrate, die in der Hybridtechnologie Verwendung finden, weisen in dieser Hinsicht eine Verbesserung der physikalischen und elektrischen Eigenschaften auf. Der Einsatzbereich der $Al_2O_3$ Keramik wird jedoch durch die Sprödigkeit auf Substratgrößen kleiner als 10 x 10 cm begrenzt.

Um die genannten Schwierigkeiten dieser Technologien zu vermeiden, wurden in neuerer Zeit Metallsubstrate mit Emailbeschichtung auch als Basismaterial für Leiterplatten herangezogen. Hierbei ließen sich die guten physikalischen und elektrischen Eigenschaften mit ausgezeichneter mechanischer Stabilität vereinen.

Jedes glasartige Material, wie auch ein Email es ist, hat einen temperaturabhängigen, weit ausgedehnten Erweichungsbereich. Dies führt dazu, daß z. B. in der bekannten Emailtechnologie das Einbrennen einer Emailschicht mit der dafür notwendigen Erniedrigung der Viskosität zum Zusammenschmelzen der Emailpartikel erfolgen muß, aber eine ausreichende Härte oder Festigkeit erst durch Abkühlen auf eine erheblich geringere Temperatur ermöglicht wird. Der Unterschied zwischen Einbrenn- und max. Gebrauchstemperatur beträgt normalerweise 300 bis 400 °C.

Wird für die Herstellung z. B. von Leiterplatten aus emaillierten Stahlsubstraten die Siebdrucktechnik eingesetzt, so wäre nach einer Einbrenntemperatur für die Emailschicht von z. B. 850 °C eine Brenntemperatur für die Leiterbahnen von nicht über 550 °C möglich.

Zwar konnten spezielle Emailtypen entwickelt werden, aber oberhalb von ca. 620-650°C erweichen auch diese, so daß es notwendig war, für eine solche Maximaltemperatur geeignete Siebdruckpasten zu entwickeln. Wünschenswert ist also die Verwendung der bei Keramiksubstraten üblichen Pasten. Einer einfachen Verschiebung des Erweichungsbereiches zu höheren Temperaturen spricht jedoch die Tatsache entgegen, daß bei Temperaturen von 900 °C und mehr im Stahl Gefügeveränderungen erfolgen, die zwangsläufig zu einer gewissen bleibenden Verformung des Substrats führen, so daß die geforderte Planheit nicht mehr eingehalten werden kann.

Überraschenderweise wurde nun gefunden, daß man bei Emaillierungen mit aus der Glasphase entstehendem Gefüge aus mindestens 2 unterschiedlichen Phasen den Temperaturunterschied zwischen Einbrennen der Emailschicht einerseits und der Leiterbahnen andererseits so weit schrumpfen lassen kann, daß mit weniger als 900 °C eine glatte und geschlossene, d. h. porenfreie Emailschicht erzeugt und darauf die Metallschicht bei 850 °C eingebrannt werden kann.

Gegenstand der vorliegenden Erfindung sind neue Emaillierungen mit aus der Glasphase entstandenen heterogenem Gefüge aus mindestens zwei unterschiedlichen Phasen, die durch elektrophoretische Abscheidung homogener alkalihaltiger Emails aus einer wäßrigen Suspension und einer Wärmebehandlung zwischen 800 und 1 000 °C erhältlich sind.

Für die besonderen Eigenschaften dieser erfindungsgemäßen Emaillierungen scheint die Zusammensetzung des Emails von entscheidender Bedeutung zu sein. Die gefundenen, günstigen Eigenschaften des Emails werden durch folgende oxidische Bestandteile, wie sie nach dem Schmelzen zu einer Emailfritte als homogenes Glas vorliegen, erreicht:

| | | |
|---|---|---|
| $SiO_2$ | 40 - 50 % (Gew.-%) | $B_2O_3$    0 - 10 % |
| $Al_2O_3$ | 8 - 15 % | |
| $Na_2O$ | 0 - 5 % | |
| $K_2O$ | 4 - 14 % | $Na_2O+K_2O$    4 - 16 % |
| $CaO$ | 9 - 32 % | $CaO+BaO$    25 - 35 % |
| $BaO$ | 0 - 20 % | |

2

MgO, MoO$_3$ und TiO$_2$ können bis zu 3 % als « Begleitoxide » vorhanden sein.
Besonders bevorzugt sind Emailfritten mit der Zusammensetzung :

| | |
|---|---|
| SiO$_2$ | 40-45 % (Gew.-%) |
| Al$_2$O$_3$ | 10-14 % |
| Na$_2$O | 0-3 |
| K$_2$O | 5-12 |
| CaO + BaO | 26-30 |
| B$_2$O$_3$ | 0-5 |

Die Emaillierung wird im allgemeinen elektrophoretisch aufgebracht, doch ist es auch ohne weiteres möglich, das Emailpulver pulverelektrostatisch oder mittels einer das Emailpulver enthaltenden Paste aufzubringen.

Nach DE-PS 16 21 406.5 ist ein Verfahren zum elektrophoretischen Auftrag von anorganischen, oxidischen Oberflächen-Schutzschichten bekannt. Für die hohe Qualität des Auftrags in Bezug auf Gleichmäßigkeit und Beschichtung von Lochwandungen, die bei der Herstellung der emaillierten Stahlsubstrate als Basis für Leiterplatten gefordert wird, ist die Anwendung eines elektrophoretischen Auftragsverfahren optimal.

Mit Hilfe der erfindungsgemäßen Emaillierungen ist es möglich, die qualitativen Vorteile des oben genannten patentierten Verfahrens voll auszunutzen. Der großtechnische Einsatz dieses Verfahrens hat in den vergangenen Jahren zu hochwertigen Beschichtungen in der Emailindustrie geführt und die praktische Anwendbarkeit unter Beweis gestellt. Ein wesentlicher Punkt für die Durchführbarkeit ist dabei die Abscheidung des Emails aus einer wäßrigen Suspension. Zwar sind labormäßig auch elektrophoretische Aufträge aus Email-Suspensionen mit organischen Lösungsmitteln bekannt, aber die praktische Anwendung bereitet erhebliche Schwierigkeiten.

Nach einem solchen System wird gemäß US-PS 4.355.115 und US-PS 4.358.541 verfahren, um Emailschichten auf Stahlsubstrate zur Herstellung von Leiterplatten zu erzeugen. Die dabei eingesetzten Emails sind jedoch nur auf diesem Weg abscheidbar. Sie ergeben aus Suspensionen mit Wasser als Suspensionsmittel keine elektrophoretisch abgeschiedenen Schichten.

Die erfindungsgemäßen Emails haben den Vorteil, daß sie sich aus wäßriger Suspension mit den hervorragenden Eigenschaften des Verfahrens nach DE-PS 16 21 406 elektrophoretisch abscheiden lassen und trotz ihres Alkaligehaltes sehr gute elektrische Werte gewährleisten.

Das Email wird nach dem Auftrag auf das Stahlsubstrat und dem Trocknen der Schicht bei ca. 80-100 °C einer Wärmebehandlung, d. h. einem Einbrennvorgang unterzogen. Hierbei werden Temperaturen unterhalb 900 °C, vorzugsweise 850-900 °C angewendet. Die erfindungsgemäße Zusammensetzung läßt es zu, daß bei Beginn des Einbrennens eine ausreichend fließende Glasstruktur die Emailteilchen zu einer geschlossenen, porenfreien Schicht zusammenschmelzen läßt. Überraschenderweise entwickeln sich beim Einbrand Kristallphasen, die zusammen mit der verbleibenden Glasmatrix das temperaturabhängige Erweichungsverhalten so stark heraufsetzen, daß die Schicht nach beendetem Einbrennvorgang aushalten kann, ohne sich dabei zu verändern. Somit kann ein später aufgebrachter Leiterbahndruck bei z. B. 850 °C wärmebehandelt werden.

Durch die spezielle Zusammensetzung des Emails und den geeigneten Einbrennvorgang entsteht aus den homogenen Emailteilchen eine heterogene, mehrphasige Emailschicht.

Die mit den erfindungsgemäßen Emaillierungen überzogenen Stahlsubstrate können vielfältig angewandt werden.

Neben den erwähnten Einsetzmöglichkeiten in der Elektronik sind zusätzliche Anwendungen für höhere Temperaturbeanspruchung denkbar, bei denen aus konstruktiven oder materialbedingten Gründen eine Erhöhung der Einbrenntemperatur über 900 °C nicht möglich ist.

Die Erfindung soll anhand der folgenden Beispiele noch näher erlautert werden.

## Beispiel 1

Ein Email mit der oxidischen Zusammensetzung (1) wird zu einer wäßrigen Suspension unter Beifügung von Schwebemitteln, wie Ton, Bentonit usw., in einer Kugelmühle vermahlen. Die Mahlfeinheit beträgt 3 Einheiten Rückstand auf einem Sieb mit 16.900 Maschen/cm² mittels Meßvorrichtung nach Bayer.

Diese Suspension wird elektrophoretisch verarbeitet, wobei die Emailteilchen sich bei einer angelegten Spannung aus einer äußeren Stromquelle von 100 V innerhalb von 17 sec. auf der Anode abscheiden, um eine ausreichende Schichtdicke nach dem Einbrand von ca. 140 μm zu ergeben. Nach Abspülen der locker anghaftenden, nur durch den Tauchvorgang aufgetragenen Emailteilchen in einem mit Wasser gefüllten Spülbecken wird die auf der Ware verbleibende, elektrophoretisch abgeschiedene Schicht getrocknet und bei 890 °C 30 min. lang eingebrannt.

Hierbei kommt es zu einem Aufschmelzen der Schicht derart, daß eine geschlossene porenfreie Oberfläche entsteht. Gleichzeitig mit dem Aufschmelzen scheiden sich aus dem Glas kristalline Phasen. aus, deren Anteil am Gesamtsystem im Verlauf des Einbrennens so hoch wird, daß ein derart hergestelltes emailliertes Metallsubstrat wiederholt Temperaturen bis zu 900 °C ausgesetzt werden kann. ohne dadurch irgendwelche Beschädigungen der Emailschicht zu erfahren.

Ein auf diese Weise hergestelltes Substrat wird mit handelsüblicher Ag/Pd-Paste bedruckt. wobei die Peaktemperatur beim Einbrand 850 °C beträgt und in 10 min. durchlaufen wird. Die so aufgebrachten Leiterbahnen zeigen ausgezeichnete Haftung, Lötbarkeit und Bondbarkeit.

| (1) | |
|---|---|
| $SiO_2$ | 44,8 |
| $Al_2O_3$ | 13,0 |
| $Na_2O$ | 3,8 |
| $K_2O$ | 12,0 |
| CaO | 10,5 |
| BaO | 15,9 |

Beispiel 2

Ein Email der Zusammensetzung (2) wird in gleicher Weise wie in Beispiel 1 angegeben elektrophoretisch abgeschieden, gespült und getrocknet. Der Einbrand erfolgt im Kammerofen mit einer simulierten Temperaturkurve, wie sie in einem Durchlaufofen durchfahren wird, derart, daß die Peaktemperatur 890 °C beträgt und in 20 min durchlaufen wird. Ein auf diese Weise hergestelltes emailliertes Stahlsubstrat wird in Siebdrucktechnik mit handelsüblicher Au-Paste bedruckt und diese in einem Durchlaufofen bei 850 °C 10 min eingebrannt.

Zur Herstellung elektrischer Anschlüsse werden dann den Enden der Leiterzüge in einem zweiten Druckvorgang Lötpunkte aus Au/Pd-Paste aufgebracht und ebenfalls bei 850 °C 10 min eingebrannt. Die Au-Leiterzüge weisen den in den Datenblättern der Hersteller angegebenen Flächenwiderstand auf, die Au/Pd-Punkte zeigen ausgezeichnete Lötbarkeit.

| (2) | |
|---|---|
| $SiO_2$ | 40,2 |
| $Al_2O_3$ | 12,0 |
| $K_2O$ | 5,2 |
| CaO | 26,7 |
| MgO | 2,2 |
| $B_2O_3$ | 9,6 |
| $MoO_3$ | 2,9 |
| $TiO_2$ | 1,2 |

Beispiel 3

Ein Email der Zusammensetzung (1) wird in gleicher Weise, wie in Beispiel 1 angegeben, für die elektrophoretische Beschichtung aufbereitet.

Für die Beschichtung wird ein Stahlträger mit Bohrungen eingesetzt, derart, daß die Bohrungen einen Durchmesser von 1,2 mm aufweisen und die Bohrungseingänge rechtwinklig verlaufen, d. h. nicht abgerundet sind. Nach der elektrophoretischen Beschichtung (50 V, 24 sec) werden lose anhatende Emailteilchen durch einen Spülvorgang entfernt und das emaillierte Substrat bei 890 °C 30 min gebrannt.

Die erhaltene Schichtdicke auf der Substratoberfläche und in den Bohrungen beträgt ca. 170 µm, die Durchschlagsfertigkeit in den Bohrungseingängen ist > 1 KV.

Die Aufbringung von Leiterstrukturen und die Durchkontaktierung von Bohrungen erfolgt durch einen Druckvorgang je Seite mit handelsüblicher Ag/Pd-Paste, die im Durchlaufofen bei 850 °C 10 min eingebrannt wird. Die so hergestellte Leiterplatte wird mit bedrahteten Bauelementen bestückt. Die Lötung der Bauelemente erfolgt in einer Wellenlötmaschine mit handelsüblichem Pb/Sn-Lot.

Beispiel 4

Ein Email mit der oxidischen Zusammensetzung (2) wird zusammen mit 0,15 % Silikonöl (Si-H-funktionell) trocken gemahlen, derart, daß auf einem Sieb mit einer Maschenweite von 40 µm ein Rückstand von 0,5 bis 1 % verbleibt.

Das auf diese Weise erhaltene Pulver wird mit 35 % (bezogen auf die Menge des Emailpulvers) eines Siebdrucköls auf Basis Pinienöl angeteigt. Diese Mischung wird auf einem Walzenstuhl homogenisiert. so daß eine einheitliche Paste entsteht.

Diese Emailpaste wird zur ganzflächigen Beschichtung eines entsprechend Beispiel 1 hergestellten. emaillierten Stahlsubstrates verwendet. Die Applikation der Emailpaste erfolgt mittels Siebdrucktechnik mit einem Edelstahlsieb der Maschenweite 200 mesh. Die Emailpaste wird bei 200 °C 1 h getrocknet und anschließend im Durchlaufofen bei einer Peaktemperatur von 890 °C 10 min eingebrannt.

Auf diese Weise lassen sich Emailschichtdicken aufbauen (z. B. 500 µm) die in dieser Dicke auf elektrophoretischem Wege nicht ohne weiteren zugänglich sind.

Beispiel 5

Auf ein entsprechend Beispiel 1 mit einem Email der Zusammensetzung (1) hergestelltes emailliertes Stahlsubstrat werden Leiterzüge mit einer handelsüblichen Au/Paste in Siebdrucktechnik aufgebracht und im Durchlaufofen bei 890 °C min eingebrannt. In einem zweiten Schritt werden diese Leiterzüge bis auf ihre Lötpunkte vollflächig mit einer Emailpaste entsprechend Beispiel 4 bedruckt. Die Emailpaste wird unter gleichen Bedingungen eingebrannt und hat danach eine Schichtdicke von ca. 50 μm. In einem dritten Schritt werden auf die mit Emailpaste bedruckte Flächen Leiterzüge wiederum mit Au/Paste in Form von Überkreuzungen aufgebracht und ebenfalls bei 890 °C 10 min eingebrannt.

Die Leiterzüge weisen hohe Spannungsfestigkeit gegeneinander auf und zeigen, daß Dickfilmpasten auf Emailbasis als Dielektrikumpasten eingesetzt werden können.

Beispiel 6

Ein Email mit der oxidischen Zusammensetzung (2) wird zusammen mit 0,6 % Silikonöl trocken gemahlen, derart, daß auf einem Sieb mit einer Maschenweite von 40 μm ein Rückstand von 0,5 bis 1 % verbleibt.

Das auf diese Weise erhaltene Pulver wird in den Fluidisierbehälter einer geeigneten pulverelektrostatischen Einrichtung gefüllt. Mittels zugehöriger Sprühpistole wird das Pulver elektrostatisch aufgeladen und auf dem Stahlsubstrat abgeschieden. Der Einbrand erfolgt in gewohnter Weise bei 890 °C innerhalb von 30 Minuten.

Derart hergestellte emaillierte Stahlsubstrate können wie beschrieben (Beispiel 1, 2, 3 und 5) zur Herstellung von Schaltungsstrukturen in Dickfilmtechnik herangezogen werden.

Beispiel 7

In der Elektrotechnik ist es in manchen Fällen wünschenswert, dreidimensional gestaltete Leiterplatten einsetzen zu können. Hierzu werden 2 verschiedene Metallkörper ausgewählt, eine Platte mit 45° gewinkelten und eine mit rechtwinkligen Kanten. Die Emaillierung mit einem Email der Zusammensetzung (1) und der Einbrand erfolgen wie in Beispiel 3 beschrieben. Aufgrund der im Moment des Aufschmelzens eintretenden kristallisation und der hierdurch bedingten Zunahme der Zähigkeit ist esmit diesem Email möglich, auch rechtwinklige Kanten (d. h., Kanten mit kleinen Krümmungsradien) einwandfrei zu beschichten.

## Patentansprüche

1. Emaillierung mit aus der Glasphase entstehendem heterogenem Gefüge aus mindestens zwei unterschiedlichen Phasen, erhältlich durch Aufbringen von homogenem alkalihaltigem Emailpulver der Zusammensetzung

| | |
|---|---|
| $SiO_2$ | 40-50 Gew.-% |
| $Al_2O_3$ | 8-15 Gew.-% |
| $Na_2O + K_2O$ | 4-16 Gew.-% |
| $CaO + BaO$ | 25-35 Gew.-% |
| $MgO$ | 0-3 Gew.-% |
| $B_2O_3$ | 0-10 Gew.-% |

auf ein Substrat und anschließende Wärmebehandlung bei Temperaturen zwischen 850 und 1 000 °C.

2. Emaillierung gemäß Anspruch 1, dadurch gekennzeichnet, daß die Aufbringung durch elektrophoretische Abscheidung aus einer wäßrigen Suspension erfolgt.

3. Emaillierung gemäß Anspruch 1, dadurch gekennzeichnet, daß die Aufbringung durch pulverelektrostatischen Auftrag erfolgt.

4. Emaillierung gemäß Anspruch 1, dadurch gekennzeichnet, daß die Aufbringung durch Auftrag einer das Emailpulver enthaltenden Paste erfolgt.

5. Verwendung einer Emaillierung gemäß einem der vorstehenden Ansprüche zur Beschichtung von Metallsubstraten.

6. Verwendung einer Emaillierung gemäß Anspruch 4 zur Beschichtung von Glas- oder Keramiksubstraten.

7. Verwendung einer Emaillierung gemäß einem der Ansprüche 1 bis 4, zur Beschichtung von gelochten Metallkernen für elektrische Leiterplatten.

8. Verwendung einer Emaillierung gemäß Anspruch 4 zur Abdeckung von Leiterstrukturen in Mehrschichtschaltungen.

9. Verwendung einer Emaillierung gemäß einem der Ansprüche 1 bis 4 zur Herstellung eines emaillierten Trägers für elektronische Schaltungen mit passiven Bauelementen in Dick- und Dünnfilmtechnik.

10. Verwendung einer Emaillierung gemäß einem der Ansprüche 1 bis 4 zur Herstellung eines emaillierten Trägers für elektronische Schaltungen mit gehäusten und ungehäusten Bauelementen.

## Claims

1. An enamel with a heterogeneous structure formed from the glass phase and comprising at least two different phases, obtainable by application of a homogeneous alkali-containing enamel powder having the following composition

| | |
|---|---|
| $SiO_2$ | 40-50 % by weight |
| $Al_2O_3$ | 8-15 % by weight |
| $Na_2O \div K_2O$ | 4-16 % by weight |
| $CaO + BaO$ | 25-35 % by weight |
| $MgO$ | 0-3 % by weight |
| $B_2O_3$ | 0-10 % by weight |

to a substrate and subsequent heat treatment at temperatures of 550 to 1 000 °C.

2. An enamel as claimed in claim 1, characterized in that the enamel powder is applied by electrophoretic deposition from an aqueous suspension.

3. An enamel as claimed in claim 1, characterized in that the enamel powder is applied by electrostatic powder coating.

4. An enamel as claimed in claim 1, characterized in that the enamel powder is applied by application of a paste containing the enamel powder.

5. The use of the enamel claimed in any of the preceding claims for the coating of metal substrates.

6. The use of the enamel claimed in claim 4 for the coating of glass or ceramic substrates.

7. The use of the enamel claimed in any of claims 1 to 4 for the coating of perforated metal cores for electrical circuit boards.

8. The use of the enamel claimed in claim 4 for covering circuit structures in multilayer circuits.

9. The use of the enamel claimed in any of claims 1 to 4 for the production of an enamelled support for electronic circuits with passive components by thick and thin film coating.

10. The use of the enamel claimed in any of claims 1 to 4 for the production of an enamelled support for electronic circuits with housed and unhoused components.

## Revendications

1. Emaillage à texture hétérogène produite à partir de la phase vitreuse, constituée d'au moins deux phases différentes, pouvant être obtenu par application d'une poudre d'émail homogène contenant un alcali, de composition ·

| | |
|---|---|
| $SiO_2$ | 40-50 % en poids |
| $Al_2O_3$ | 8-15 % en poids |
| $Na_2O \div K_2O$ | 4-16 % en poids |
| $CaO \div BaO$ | 25-35 % en poids |
| $MgO$ | 0-3 % en poids |
| $B_2O_3$ | 0-10 % en poids |

sur un substrat puis traitement à la chaleur à des températures comprises entre 850 et 1 000 °C.

2. Emaillage suivant la revendication 1, caractérisé en ce que l'application est effectuée par déposition électrophorétique à partir d'une suspension aqueuse.

3. Emaillage suivant la revendication 1, caractérisé en ce que l'application est effectuée par un dépôt électrostatique de poudre.

4. Emaillage suivant la revendication 1, caractérisé en ce que l'application est effectuée par dépôt d'une pâte contenant de la poudre d'émail.

5. Utilisation d'un émaillage suivant l'une des revendications précédentes pour le revêtement de substrats métalliques.

6. Utilisation d'un émaillage suivant la revendication 4 pour le revêtement de substrats de verre ou de céramique.

7. Utilisation d'un émaillage suivant l'une des revendications 1 à 4 pour le revêtement de noyaux métalliques perforés pour plaquettes électriques de circuits imprimés.

8. Utilisation d'un émaillage suivant la revendication 4 pour la protection de structures conductrices dans des circuits à plusieurs couches.

9. Utilisation d'un émaillage suivant l'une des revendications 1 à 4 pour la production d'un support émaillé pour circuits électroniques à composants passifs selon la technique de déposition d'un film épais et d'un film mince.

10. Utilisation d'un émaillage suivant l'une des revendications 1 à 4 pour la production d'un support émaillé pour circuits électroniques à composants logés ou non dans un boîtier.